# EUROPEAN PATENT APPLICATION

(11) **EP 3 267 569 A1**
(43) Date of publication of application: **10.01.2018**
(21) Application number: 16761498.1
(22) Date of filing: 25.02.2016
(51) Int. Cl.: H02M 3/28, H01F 30/10, H05K 1/16

(54) **ISOLATED SWITCHING POWER SOURCE**

(30) Priority: 06.03.2015 JP 2015044458
(71) Applicant: FDK Corporation, Tokyo 108-8212 (JP)
(72) Inventor: HAMADA, Kenji, Tokyo 108-8212 (JP); NAGAYOSHI, Tomoyuki, Tokyo 108-8212 (JP); SATO, Tadashi, Tokyo 108-8212 (JP); FUKUI, Norio, Tokyo 108-8212 (JP)
(74) Representative: Epping - Hermann - Fischer
(86) International application number: PCT/JP2016/055546
(87) International publication number: WO 2016/143527

(57) **Abstract**

An isolated switching power supply of the present invention includes: a first circuit board 10 provided with a pattern of a primary winding L11 constituting an isolation transformer T1; a second circuit board 20 provided with patterns of secondary windings L21 and L22 constituting the isolation transformer T1, wherein a secondary winding pattern portion 22 is arranged to face a primary winding pattern portion 12 of the first circuit board 10 at a predetermined interval G; and a core 30 inserted into the primary winding L11 of the first circuit board 10 and the secondary windings L21 and L22 of the second circuit board 20 and made of a magnetic body constituting the isolation transformer T1.

## Description

### Technical Field

The present invention relates to an isolated switching power supply.

### Background Art

An isolated switching power supply is well-known, such as a flyback, forward, push-pull, or full-bridge isolated DC-DC switching power supply, an isolated AC-DC switching power supply, and an isolated DC-AC inverter, wherein an isolation transformer electrically isolates input and output. Along with the reduction in the size of electronic devices in recent years, there is an increasing demand for reducing the size of the isolated switching power supply in an electronic device including the isolated switching power supply as a power supply.

An example of prior art corresponding to the demand includes a well-known isolated switching power supply using a multiplayer board transformer as an isolation transformer. In the multilayer board transformer, coil patterns are formed on surfaces of a plurality of base materials, and the base materials are laminated and integrated through insulating layers, for example. A primary winding and a secondary winding are formed by the coil patterns (for example, see Patent Document 1). The multilayer board transformer can be used to reduce the size and the thickness of the isolation transformer, and this can reduce the size of the isolated switching power supply.

### Prior Art Document

### Patent Document

Patent Document 1: Japanese Patent Laid-Open No. 2010-093174

### Summary of the Invention

### Problems to be solved by the Invention

In the isolated switching power supply, a resonant inverter is adopted as an inverter circuit in some cases, and LC resonance is used to perform soft switching. The soft switching is a technique of using the LC resonance to reduce the switching loss by performing switching at a zero crossing point where the current or the voltage is 0. In the soft switching using the LC resonance, constants of a coil and a capacitor constituting an LC resonant circuit can be set to appropriate constants to realize switching at the zero crossing point where the current or the voltage is 0.

However, in the soft switching using the LC resonance, the inverter circuit requires the capacitor and the coil constituting the LC resonant circuit. Particularly, a choke coil used as a coil of the LC resonant circuit is often large-sized and expensive in general, and this may lead to a problem of an increase in the cost or the size of the isolated switching power supply.

The present invention has been made in view of the circumstances, and an object of the present invention is to provide a small-sized isolated switching power supply with less switching loss at a low cost.

### Means for Solving the Problems

### <First Aspect of the Present Invention>

A first aspect of the present invention provides an isolated switching power supply including: a first circuit board provided with a pattern of a primary winding constituting an isolation transformer; a second circuit board provided with a pattern of a secondary winding constituting the isolation transformer, wherein a part provided with the secondary winding is arranged to face a part provided with the primary winding of the first circuit board at a predetermined interval; and a core inserted into the primary winding of the first circuit board and the secondary winding of the second circuit board and made of a magnetic body constituting the isolation transformer.

The pattern of the primary winding constituting the isolation transformer is formed on the first circuit board, and the pattern of the secondary winding constituting the isolation transformer is formed on the second circuit board. The part provided with the primary winding of the first circuit board and the part provided with the secondary winding of the second circuit board are arranged to face each other at the predetermined interval. Therefore, the interval between the first circuit board and the second circuit board can be adjusted to adjust a degree of coupling (coupling coefficient) of the primary winding and the secondary winding of the isolation transformer, and this can adjust a leakage inductance of the isolation transformer to a desired value.

As described, in the isolated switching power supply, the soft switching using the LC resonance can realize the reduction in the switching loss through the switching at the zero crossing point where the current or the voltage is 0. The present invention can use the leakage inductance of the isolation transformer in the soft switching using the LC resonance. More specifically, the leakage inductance of the isolation transformer can be used as an inductance of the LC resonance or as part of the inductance of the LC resonance. The interval between the first circuit board and the second circuit board can be adjusted to adjust the leakage inductance of the isolation transformer to a desired value, and a constant of the LC resonant circuit of the soft switching can be highly accurately set to an appropriate constant.

In this way, the isolated switching power supply according to the present invention allows using the leakage inductance of the isolation transformer in the LC resonance of the soft switching. More specifically, the isolated switching power supply according to the present invention can eliminate the need to mount a choke coil that is generally large and expensive or can reduce the size of a conventional choke coil, thereby allowing to perform the soft switching using the LC resonance. This can reduce the possibility of an increase in the cost or an increase in the size while realizing the reduction in the switching loss through the switching at the zero crossing point in the isolated switching power supply.

As a result, the first aspect of the present invention can obtain an effect that a small-sized isolated switching power supply with less switching loss can be provided at a low cost.

### <Second Aspect of the Present Invention>

A second aspect of the present invention provides the isolated switching power supply according to the first aspect of the present invention, wherein the first circuit board includes an inverter circuit, and the second circuit board includes a converter circuit.

According to the second aspect of the present invention, the inverter circuit constituting a circuit on a primary side (input side) is mounted on the first circuit board, and the converter circuit constituting a circuit on a secondary side (output side) is mounted on the second circuit board. This can more efficiently reduce the space. Therefore, the size and the cost of the isolated switching power supply can be further reduced.

### <Third Aspect of the Present Invention>

A third aspect of the present invention provides the isolated switching power supply according to the first or second aspect of the present invention, further including an interval defining member provided between the first circuit board and the second circuit board and configured to define the predetermined interval between the part provided with the primary winding of the first circuit board and the part provided with the secondary winding of the second circuit board.

According to the third aspect of the present invention, the interval defining member is interposed between the part provided with the primary winding of the first circuit board and the part provided with the secondary winding of the second circuit board to directly define the interval. This can further highly accurately set the leakage inductance of the isolation transformer to the desired value.

### Advantageous Effects of the Invention

The present invention can obtain an effect that a small-sized isolated switching power supply with less switching loss can be provided at a low cost.

### Brief Description of the Drawings

FIG. 1 is a circuit diagram illustrating main parts of a circuit of an isolated switching power supply according to the present invention.
FIG. 2 is a perspective view illustrating the main parts of the isolated switching power supply according to the present invention.
FIG. 3 is an exploded perspective view illustrating the main parts of the isolated switching power supply according to the present invention.
FIG. 4 is a front view illustrating the main parts of the isolated switching power supply according to the present invention.

### Mode for Carrying out the Invention

Hereinafter, an embodiment of the present invention will be described with reference to the drawings.

Note that the present invention is not particularly limited to the embodiment described below, and it is obvious that various modifications can be made within the scope of the invention written in the claims.

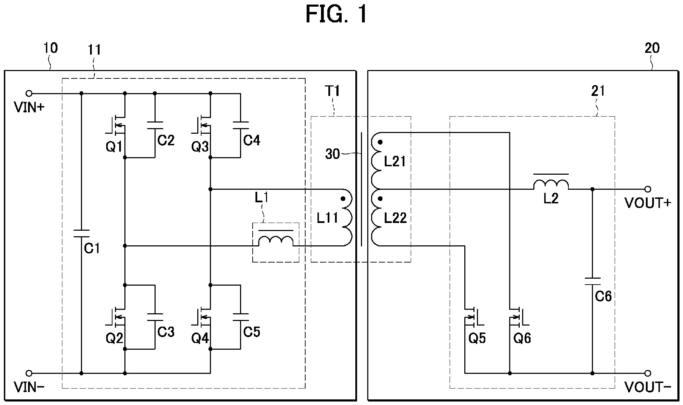

FIG. 1 is a circuit diagram illustrating main parts of a circuit of an isolated switching power supply according to the present invention.

An example of the isolated switching power supply according to the present invention is a full-bridge isolated DC-DC converter. However, the isolated switching power supply according to the present invention is not particularly limited to the full-bridge isolated DC-DC converter. For example, the present invention can be implemented in isolated DC-DC converters in various formats, such as flyback, forward, and push-pull converters, and the present invention can also be implemented in an isolated AC-DC converter, an isolated DC-AC inverter, and the like.

The isolated switching power supply according to the present invention includes an inverter circuit 11, a converter circuit 21, and an isolation transformer T1.

The inverter circuit 11 includes field effect transistors (FETs) Q1 to Q4 and capacitors C1 to C5. The field effect transistors Q1 to Q4 as switching elements constitute a well-known full-bridge inverter circuit. The field effect transistors Q1 to Q4 are turned on or off at the same time by gate signals output by a control circuit not shown and are turned on or off such that the field effect transistors Q2 and Q3 are in opposite phase to the field effect transistors Q1 and Q4. The capacitor C1 is connected between a + input terminal VIN+ and a - input terminal VIN-. The capacitors C2 to C4 are connected in parallel between source and drain terminals of the field effect transistors Q1 to Q4 and constitute an LC resonant circuit in soft switching. The alternating current generated by the full-bridge inverter circuit flows to the converter circuit 21 through the isolation transformer T1.

Note that the capacitors C2 to C4 may be constituted by parasitic capacitances between drains and sources of the field effect transistors Q1 to Q4.

The inverter circuit 11 further includes a leakage inductance L1. The leakage inductance L1 does not exist as an electronic component provided with a choke coil or the like, but is an inductance component generated on a primary side of the isolation transformer T1 as a component equivalent to a coil. The leakage inductance L1 constitutes the LC resonant circuit in the soft switching along with the capacitors C2 to C4.

The converter circuit 21 includes field effect transistors Q5 and Q6, a coil L2, and a capacitor C6. The field effect transistors Q5 and Q6 are turned on or off by gate signals output by a control circuit not shown and constitute a well-known synchronous rectifier circuit along with the coil L2 and the capacitor C6. The power converted to a predetermined DC voltage by the synchronous rectifier circuit is output from a + output terminal VOUT+ and a - output terminal VOUT-.

The isolation transformer T1 includes a primary winding L11, secondary windings L21 and L22, and a core 30. A winding finish end of the primary winding L11 is connected to a connection point of the source terminal of the field effect transistor Q1 and the drain terminal of the field effect transistor Q2, and a winding start end of the primary winding L11 is connected to a connection point of the source terminal of the field effect transistor Q3 and the drain terminal of the field effect transistor Q4. A winding finish end of the secondary winding L21 and a winding start end of the secondary winding L22 are connected, and the connection point (center tap) of the secondary windings L21 and L22 are connected to one end side of the coil L2. A winding start end of the secondary winding L21 is connected to the drain terminal of the field effect transistor Q6. A winding finish end of the secondary winding L22 is connected to the drain terminal of the field effect transistor Q5.

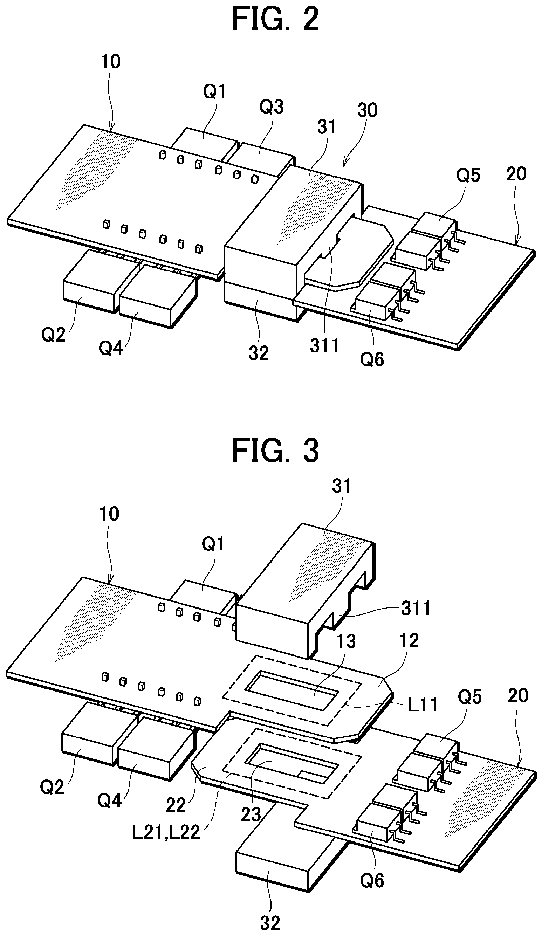

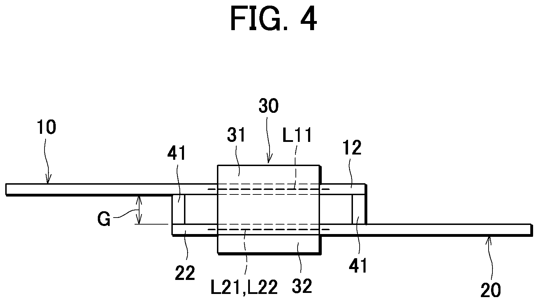

FIG. 2 is a perspective view illustrating main parts of the isolated switching power supply according to the present invention. FIG. 3 is an exploded perspective view of the main parts. FIG. 4 is a front view of the main parts.

The isolated switching power supply according to the present invention includes a first circuit board 10, a second circuit board 20, the core 30, and a plurality of spacers 41.

The first circuit board 10 is provided with the inverter circuit 11. More specifically, the first circuit board 10 is provided with the field effect transistors Q1 to Q4 constituting the inverter circuit 11. The first circuit board 10 is also provided with the capacitors C1 to C5 constituting the inverter circuit 11 (not shown in FIGS. 2 to 4). Furthermore, the first circuit board 10 is a multilayer board, and a pattern of the primary winding L11 constituting the isolation transformer T1 is formed.

The second circuit board 20 is provided with the converter circuit 21. More specifically, the second circuit board 20 is provided with the field effect transistors Q5 and Q6 constituting the converter circuit 21. The second circuit board 20 is also provided with the coil L2 and the capacitor C6 constituting the converter circuit 21 (not shown in FIGS. 2 to 4). Furthermore, the second circuit board 20 is a multilayer board, and patterns of the secondary windings L21 and L22 constituting the isolation transformer T1 are formed.

The first circuit board 10 and the second circuit board 20 are arranged such that a portion 12 provided with the pattern of the primary winding L11 of the first circuit board 10 (hereinafter, referred to as "primary winding pattern portion 12") and a portion 22 provided with the patterns of the secondary windings L21 and L22 of the second circuit board 20 (hereinafter, referred to as "secondary winding pattern portion 22") face each other at a predetermined interval G. The primary winding pattern portion 12 of the first circuit board 10 is provided with a rectangular insertion hole 13 at a part corresponding to the inside of the primary winding L11. The secondary winding pattern portion 22 of the second circuit board 20 is provided with an insertion hole 23 in the same shape and the same size as the insertion hole 13 of the first circuit board 10, at a part corresponding to the inside of the secondary windings L21 and L22.

The core 30 is a member formed by a magnetic body constituting the isolation transformer T1 and includes a first core portion 31 and a second core portion 32. The first core portion 31 is provided with a rectangular columnar protrusion 311 at the center. The core 30 is arranged on the insertion hole 13 of the first circuit board 10 and the insertion hole 23 of the second circuit board 20, with the protrusion 311 of the first core portion 31 being inserted.

The plurality of spacers 41 as "interval defining members" are provided between the first circuit board 10 and the second circuit board 20. The plurality of spacers 41 are members that define the predetermined interval G between the primary winding pattern portion 12 provided with the primary winding L11 of the first circuit board 10 and the secondary winding pattern portion 22 provided with the secondary windings L21 and L22 of the second circuit board 20. The first circuit board 10 and the second circuit board 20 are screwed and connected to the plurality of spacers 41.

It is obvious that the "interval defining members" are not particularly limited to the spacers 41, and the "interval defining members" may be any members as long as the members can define the predetermined interval G between the first circuit board 10 and the second circuit board 20. For example, an insulation sheet or the like may be interposed between the first circuit board 10 and the second circuit board 20.

In the isolated switching power supply according to the present invention described above, the primary winding L11 constituting the isolation transformer T1 is formed by a pattern on the first circuit board 10, and the secondary windings L21 and L22 constituting the isolation transformer T1 are formed by patterns on the second circuit board 20. The primary winding pattern portion 12 provided with the primary winding L11 of the first circuit board 10 and the secondary winding pattern portion 22 provided with the secondary windings L21 and L22 of the second circuit board 20 are arranged to face each other at the predetermined interval G.

Therefore, the interval G between the first circuit board 10 and the second circuit board 20 can be adjusted to adjust a degree of coupling (coupling coefficient) of the primary winding L11 and the secondary windings L21 and L22 of the isolation transformer T1, and this can adjust the leakage inductance L1 of the isolation transformer T1 to a desired value. More specifically, the length of the plurality of spacers 41 can be adjusted to adjust the interval G, for example. The plurality of spacers 41 are interposed between the primary winding pattern portion 12 of the first circuit board 10 and the secondary winding pattern portion 22 of the second circuit board 20 to directly define the interval G. This can further highly accurately set the leakage inductance L1 of the isolation transformer T1 to the desired value.

The isolated switching power supply according to the present invention can use the leakage inductance L1 on the primary side of the isolation transformer T1 in the soft switching using the LC resonance. Therefore, the leakage inductance L1 on the primary side of the isolation transformer T1 can be used as an inductance of the LC resonance or as part of the inductance of the LC resonance. The interval G between the first circuit board 10 and the second circuit board 20 can be adjusted to adjust the leakage inductance L1 on the primary side of the isolation transformer T1 to the desired value, and a constant of the LC resonance circuit of the soft switching can be highly accurately set to an appropriate constant.

In this way, the isolated switching power supply according to the present invention allows to use the leakage inductance L1 on the primary side of the isolation transformer T1 in the LC resonance of the soft switching. More specifically, the isolated switching power supply according to the present invention can eliminate the need to mount a choke coil that is generally large and expensive or can reduce the size of a conventional choke coil, thereby allowing to perform the soft switching using the LC resonance. This can reduce the possibility of an increase in the cost or an increase in the size while realizing a reduction in the switching loss through the switching at a zero crossing point in the isolated switching power supply. Therefore, according to the present invention, a small-sized isolated switching power supply with less switching loss can be provided at a low cost.

In the present invention, it is preferable to mount the inverter circuit 11 constituting the circuit on the primary side (input side) on the first circuit board 10 and to mount the converter circuit 21 constituting the circuit on the secondary side (output side) on the second circuit board 20. This can more efficiently reduce the space, and the size and the cost of the isolated switching power supply can be further reduced.

According to the present invention, the primary winding L11 and the secondary windings L21 and L22 constituting the isolation transformer T1 are separately provided on the first circuit board 10 and the second circuit board 20, respectively, and the heat generated by the isolation transformer T1 can be efficiently dissipated. This can reduce the size of a heat dissipating component of the isolation transformer T1, and the cost of the isolated switching power supply can be further reduced. Adopting the configuration can individually set the thicknesses, the shapes, and the like of the primary winding L11 and the secondary windings L21 and L22, and the degree of freedom of design can be improved. Adopting the configuration also allows using a multilayer board with relatively few layers when the isolation transformer T1 is constituted by the multilayer board, and the manufacturing cost of the isolation transformer T1 based on the multilayer board can be significantly reduced.

### Explanation of Reference Signs

- 10: circuit board
- 11: inverter circuit
- 20: circuit board
- 21: converter circuit
- 30: core
- 41: spacer
- C1 to C6: capacitors
- L1: leakage inductance
- L2: coil
- L11: primary winding
- L21, L22: secondary windings
- Q1 to Q6: field effect transistors
- T1: isolation transformer

## Claims

1. An isolated switching power supply comprising:
a first circuit board provided with a pattern of a primary winding constituting an isolation transformer;
a second circuit board provided with a pattern of a secondary winding constituting the isolation transformer, wherein a part provided with the secondary winding is arranged to face a part provided with the primary winding of the first circuit board at a predetermined interval; and
a core inserted into the primary winding of the first circuit board and the secondary winding of the second circuit board and made of a magnetic body constituting the isolation transformer.

2. The isolated switching power supply according to claim 1, wherein
the first circuit board comprises an inverter circuit, and the second circuit board comprises a converter circuit.

3. The isolated switching power supply according to claim 1 or 2, further comprising
an interval defining member provided between the first circuit board and the second circuit board and configured to define the predetermined interval between the part provided with the primary winding of the first circuit board and the part provided with the secondary winding of the second circuit board.
